# EUROPÄISCHE PATENTSCHRIFT

(11) **EP 2 252 989 B1**
(45) Veröffentlichungstag und Bekanntmachung des Hinweises auf die Patenterteilung: **07.04.2021**
(21) Anmeldenummer: 09714753.2
(22) Anmeldetag: 25.02.2009
(51) Int. Cl.: F21Y 115/15, H01L 51/52

(54) **STRAHLUNGSEMITTIERENDE ANORDNUNG**
RADIATION-EMITTING ARRANGEMENT
ENSEMBLE ÉMETTANT UN RAYONNEMENT

(30) Priorität: 26.02.2008 DE 102008011239; 16.05.2008 DE 102008023874
(43) Veröffentlichungstag der Anmeldung: 24.11.2010
(73) Patentinhaber: OSRAM OLED GmbH, 93055 Regensburg (DE)
(72) Erfinder: LANG, Erwin, 93051 Regensburg (DE); KLEIN, Markus, 93105 Tegernheim (DE); WITTMANN, Martin, 93047 Regensburg (DE); BECKER, Dirk, 84085 Langquaid (DE); DOBBERTIN, Thomas, 93051 Regensburg (DE); JAEGER, Arndt, 93051 Regensburg (DE); DIEKMANN, Karsten, 94371 Rattenberg (DE)
(74) Vertreter: Epping - Hermann - Fischer
(86) Internationale Anmeldenummer: PCT/DE2009/000279
(87) Internationale Veröffentlichungsnummer: WO 2009/106067

(56) Entgegenhaltungen:
- EP-A1- 1 701 395
- WO-A-03/036596
- WO-A-03/067014
- WO-A-2006/049807
- WO-A-2007/031366
- US-A1- 2004 245 525

## Beschreibung

Es wird eine strahlungsemittierende Anordnung angegeben.

Im Bereich moderner Architektur und kreativem Design kommt heutzutage der Materialauswahl eine entscheidende Bedeutung zu, um einerseits die gewünschte Funktionalität zu gewährleisten aber andererseits auch der äußeren Formgebung entsprechend eine gewünschte Wirkung zu verleihen. Durch eine gezielte Beleuchtung lässt sich beispielsweise die Wirkung verschiedener Materialien entsprechend verstärken oder die Oberflächenbeschaffenheit gezielt hervorheben. In bekannten Anwendungen muss die Beleuchtung stets extern erfolgen, indem die entsprechenden Stellen mit dem gewünschten Licht angestrahlt beziehungsweise ausgeleuchtet werden. Eine externe Beleuchtung ist in vielen Fällen jedoch nicht möglich beziehungsweise erfordert einen nicht unerheblichen technischen und finanziellen Aufwand

Eine strahlungsemittierende Anordnung mit einem transparenten organischen strahlungsemittierendem Bauelement und einem Trägerelement mit einer zumindest teilweise nicht-transparenten Hauptoberfläche ist aus EP1701395 A1 bekannt.

Eine ohne externe Beleuchtung beleuchtete Oberfläche, deren materialspezifisches Erscheinungsbild wie etwa eine Holzmaserung, metallischer Glanz, Farben oder ähnliches erhalten bleibt, ist bis zum jetzigen Zeitpunkt nicht bekannt.

Aufgabe zumindest einer Ausführungsform ist, eine strahlungsemittierende Anordnung mit einem organischen strahlungsemittierenden Bauelement anzugeben.

Diese Aufgabe wird durch einen Gegenstand mit den Merkmalen des unabhängigen Patentanspruchs 1 gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Dass eine Schicht oder ein Element "auf" oder "über" einer anderen Schicht oder einem anderen Element oder auch "zwischen" zwei anderen Schichten oder Elementen angeordnet oder aufgebracht ist, kann dabei hier und im Folgenden bedeuten, dass die eine Schicht oder das eine Element unmittelbar im direkten mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht angeordnet sein.

"Zumindest teilweise nicht-transparent" kann in Zusammenhang mit der Hauptoberfläche des Trägerelements insbesondere bedeuten, dass die Hauptoberfläche zumindest einen oder mehrere Teilbereiche aufweist, die nicht transparent für die vom aktiven Bereich des organischen strahlungsemittierenden Bauelements erzeugte elektromagnetische Strahlung sind. Insbesondere können der zumindest eine oder die mehreren Teilbereiche der Hauptoberfläche auch nicht-transparent für das gesamte sichtbare elektromagnetische Spektrum oder eines Teilspektrums davon sein. Der zumindest eine oder die mehreren Bereiche der Hauptoberfläche können dabei für zumindest eine Wellenlänge aus der vom organischen strahlungsemittierenden Bauelement im aktiven Beriech erzeugten elektromagnetischen Strahlung und/oder für zumindest eine Wellenlänge aus dem sichtbaren elektromagnetischen Spektrum absorbierend oder reflektierend sein.

Als "externer Beobachter" wird hier und im Folgenden ein Mensch mit durchschnittlicher Sehkraft und einem durchschnittlichen Sehapparat verstanden. "Wahrnehmbar" ist in diesem Zusammenhang für einen externen Beobachter daher eine elektromagnetische Strahlung, die eine Wellenlänge und eine Intensität aufweist, die geeignet ist, einen visuellen Stimulus im Sehapparat des externen Beobachters hervorzurufen. Eine zweite elektromagnetische Strahlung kann von dem externen Beobachter aber beispielsweise nicht wahrnehmbar im Sinne der hier folgenden Beschreibung sein, wenn die zweite elektromagnetische Strahlung im Vergleich zu einer ersten elektromagnetischen Strahlung eine derart geringe Intensität aufweist, dass eine Sinneswahrnehmung der zweiten elektromagnetischen Strahlung nicht möglich ist aufgrund physikalisch-chemischer und/oder neurologischer Vorgänge hervorgerufen durch die erste elektromagnetische Strahlung im Sehapparat des externen Beobachters. Das kann hier und im Folgenden als "Überstrahlen" der zweiten elektromagnetischen Strahlung durch die erste elektromagnetische Strahlung bezeichnet werden. Weiterhin kann eine zweite elektromagnetische Strahlung von einem externen Beobachter nicht wahrnehmbar im Sinne der hier folgenden Beschreibung sein, wenn die zweite elektromagnetische Strahlung einen derart geringen Intensitätsunterschied und/oder Wellenlängenunterschied und/oder räumlichen Unterschied zu einer ersten elektromagnetischen Strahlung aufweist, so dass die erste und zweite elektromagnetische Strahlung nicht getrennt voneinander vom durchschnittlichen menschlichen Sehapparat auflösbar sind. Das kann hier und im Folgenden als "zu geringer Kontrast" bezeichnet werden. Der "externe Beobachter" sowie das Merkmal "wahrnehmbar" dienen daher zum einen einer quantitativen Charakterisierung eines Wellenlängenbereichs und einer Mindestintensität einer elektromagnetischen Strahlung, wobei die derartige Charakterisierung aber andererseits im Lichte der physiologischen und neuronalen Eigenheiten des Sehapparats zu verstehen ist.

Eine Oberfläche kann im Sinne der hier beschriebenen Anordnung "wahrnehmbar" sein, wenn zumindest ein Teil einer elektromagnetischen Strahlung, die auf die Oberfläche fällt und die Oberfläche beleuchtet, von der Oberfläche zurückgestrahlt wird und von einem externen Beobachter im obigen Sinne wahrnehmbar ist. Dass eine Oberfläche wahrnehmbar ist kann dabei insbesondere auch bedeuten, dass eine durch Farbvariationen und/oder Helligkeitsvariationen und/oder Formvariationen gegebene Oberflächenstruktur der Oberfläche wahrnehmbar ist.

Durch die Kombination des hier beschriebenen organischen strahlungsemittierenden Bauelements und des Trägerelements mit der zumindest teilweise nicht-transparenten Hauptoberfläche kann beispielsweise eine Hervorhebung und/oder Veränderung des Erscheinungsbildes der zumindest teilweise nicht-transparenten Hauptoberfläche im eingeschalteten Betriebszustand des organischen strahlungsemittierenden Bauelements im Vergleich zum ausgeschalteten Betriebszustand möglich sein. Das Erscheinungsbild der Hauptoberfläche kann beispielsweise aufgrund der Material- und/oder Oberflächenbeschaffenheit hinsichtlich Farbe, Helligkeit und/oder Glanz hervorhebbar und/oder veränderbar sein. Dies kann vor allem durch eine gezielte Beleuchtung der Hauptoberfläche durch das organische strahlungsemittierende Bauelement möglich sein, ohne dass eine externe Beleuchtung eingesetzt werden muss. Gerade dadurch, dass die erste Elektrode, die organische Schichtenfolge und die zweite Elektrode transparent sind, kann es aber auch möglich sein, dass die zumindest teilweise nicht-transparente Hauptoberfläche des Trägerelements wahrnehmbar und beobachtbar ist und im ausgeschalteten Zustand des organischen strahlungsemittierenden Bauelements ihre spezifischen Materialeigenschaften und Erscheinungsform beibehält. Weiterhin kann das organische strahlungsemittierende Bauelement auf dem Trägerelement auch zusätzlich als Schutzschicht für eine empfindliche Oberfläche des Trägerelements dienen.

Die zumindest teilweise nicht-transparente Hauptoberfläche kann dabei eine vom organischen strahlungsemittierenden Bauelement abgewandte Hauptoberfläche des Trägerelements sein. Dass kann bedeuten, dass die zumindest teilweise nicht-transparente Hauptoberfläche vom organischen strahlungsemittierenden Bauelement abgewandt angeordnet ist und dass das organische strahlungsemittierende Bauelement auf einer der zumindest teilweise nicht-transparenten Hauptoberfläche gegenüberliegenden Hauptoberfläche des Trägerelements angeordnet ist. Dabei kann das Trägerelement auf der dem organischen strahlungsemittierenden Bauelement zugewandten Seite der zumindest teilweise nicht-transparenten Hauptoberfläche ein transparentes Material aufweisen. Das transparente Material kann dabei beispielsweise Glas und/oder einen transparenten Kunststoff umfassen oder aus zumindest einem dieser Materialien sein. Die zumindest teilweise nicht-transparente Hauptoberfläche kann somit durch die Strahlungsaustrittsfläche der strahlungsemittierenden Anordnung und durch das transparente Material des Trägerelements hindurch zumindest in einem ausgeschalteten Betriebszustand des organischen strahlungsemittierenden Bauelements wahrnehmbar sein.

Die zumindest teilweise nicht-transparente Hauptoberfläche kann alternativ auch eine dem organischen strahlungsemittierenden Bauelement zugewandte Hauptoberfläche des Trägerelements sein. Insbesondere kann das Trägerelement dabei auch eines oder mehrere nicht-transparente Materialien umfassen oder daraus bestehen.

Weiterhin kann die zumindest teilweise nicht-transparente Hauptoberfläche zusätzlich oder alternativ zumindest eines oder mehrere nicht-transparente Materialien umfassen oder durch solche gebildet sein. Insbesondere kann dabei die zumindest teilweise nicht-transparente Hauptoberfläche des Trägerelements eine Beschichtung mit zumindest einem oder mehreren nicht-transparenten Materialien umfassen. Eine Beschichtung kann dabei auf einem transparenten oder nicht-transparenten Material aufgebracht sein, das zusammen mit der Beschichtung das Trägerelement bilden kann. "Aufgebracht" kann hier und im Folgenden insbesondere aufgesprüht, aufgedampft, aufgeklebt, auflaminiert oder eine Kombination daraus bedeuten.

Das zumindest eine oder die mehreren nicht-transparenten Materialien können ausgewählt sein aus Stein, Holz, Kunststoff, Textilien, Metall, Metalllegierung, Papier, Karton, farbiges Glas und jeder Kombination eines oder mehrerer dieser Materialien. Das Trägerelement kann dabei insbesondere aus einem oder mehreren der vorgenannten Materialien zumindest im Bereich der zumindest teilweise nicht-transparenten Hauptoberfläche bestehen.

Insbesondere im Falle einer wie oben beschriebenen Beschichtung können das zumindest eine oder die mehreren nicht-transparenten Materialien alternativ oder zusätzlich zu den vorgenannten Materialien auch einen Anstrichstoff aufweisen oder ein solcher sein. Ein Anstrichstoff kann dabei flüssige bis pastenförmige Stoffe und/oder Gemische aufweisen, die auf Oberflächen aufgetragen eine feste Schicht ergeben. Ein Anstrichstoff kann dabei beispielsweise Bindemittel, Farbmittel und/oder Pigmente, Füllstoffe, Lösungsmittel, Verdickungsmittel, Dispergiermittel und/oder Konservierungsmittel aufweisen. Beispielsweise kann der Anstrichstoff als Lack, Dispersionsfarbe oder Verputz ausgeführt sein. Die Bindemittel könne beispielsweise Öle der Ölfarben, Acrylharz, Epoxidharz, Acrylat-Polymere, Vinylacetat-Copolymere, gebrannter Kalk, Zement, Anhydrit und/oder Kaliwasserglas aufweisen. Weiterhin können das zumindest eine oder die mehreren nicht-transparenten Materialien im Falle einer wie oben genannten Beschichtung auch beispielsweise eine Eloxierung, beispielsweise einer Metalloberfläche, umfassen.

Das Trägerelement und damit die strahlungsemittierende Anordnung kann insbesondere Teil einer technischen, künstlerischen oder architektonischen Vorrichtung sein. Rein beispielhaft seien dabei eine Wand, eine Decke, ein Schrank, eine Arbeitsplatte, eine Marmorplatte, eine Holzplatte, eine Treppe, eine Vitrine, ein Bodenbelag, ein Gehäuse eines Geräts, ein Fahrzeug, ein Spielzeug, ein Designelement, eine Fassade eines Gebäudes, ein Rettungsweg, in Schild, ein Verkehrszeichen, eine Hinweis- und eine Informationstafel, ein Wegweiser, ein Schriftzug, ein Hausnummernschild, ein Türschild und ein Namensschild genannt.

Das organische strahlungsemittierende Bauelement kann unmittelbar und direkt auf dem Trägerelement aufgebracht sein. Das kann bedeuten, dass eine Schicht des organischen strahlungsemittierenden Bauelements in direktem mechanischen Kontakt mit dem Trägerelement steht. Die Schicht kann dabei beispielsweise ein weiter unten beschriebenes Substrat, eine weiter unten beschriebene Verkapselung oder ein Teil davon oder eine der ersten und zweiten Elektrode sein.

Weiterhin kann die strahlungsemittierende Anordnung eine Zwischenschicht zwischen dem Trägerelement und dem organischen strahlungsemittierenden Bauelement aufweisen. Das kann insbesondere dann vorteilhaft sein, wenn die dem organischen strahlungsemittierenden Bauelement zugewandte Hauptoberfläche des Trägerelements, das, wie oben beschrieben, auch die zumindest teilweise nicht-transparente Hauptoberfläche sein kann, eine Oberflächenstruktur wie etwa Erhebungen, Vertiefungen, Spitzen, mechanische Kurzschlusspartikel und/oder eine Rauhigkeit aufweist. Die Zwischenschicht kann dabei als Planarisierungsschicht ausgeführt sein, mittels derer eine plane Aufbringfläche für das organische strahlungsemittierende Bauelement ermöglich werden kann.

Die Zwischenschicht kann dabei ein transparentes festes Material in amorpher oder kristalliner Form aufweisen, etwa Gas, einen Kunststoff, einen Halbleiter, Metall oder eine Kombination aus einem oder mehreren der aufgeführten Materialien. Weiterhin kann die Zwischenschicht ein transparentes viskoses oder flüssiges Material aufweisen, etwa ein Öl, ein Gel, ein Harz, ein Silikonöl oder ein Silikongel.

Die Zwischenschicht kann weiterhin ein Gas umfassen oder durch ein Gas gebildet sein, etwa eines oder mehrere ausgewählt aus Luft, ein Edelgas, Stickstoff, Sauerstoff, Kohlendioxid und Kohlenmonoxid.

Weiterhin kann die Zwischenschicht der mechanischen Befestigung des organischen strahlungsemittierenden Bauelements auf dem Trägerelement dienen und dazu beispielsweise einen Klebstoff aufweisen oder aus einem Klebstoff sein. Der Klebstoff kann dabei als zusätzliche Schicht aufgebracht sein oder beispielsweise auch Teil einer selbstklebenden Folie sein. Die Zwischenschicht kann damit beispielsweise eine stoffschlüssige Verbindung zwischen dem Trägerelement und dem organischen strahlungsemittierenden Bauelement ermöglichen. Weiterhin kann die Zwischenschicht dabei auch eine formschlüssige Verbindung, insbesondere in einer Ausführung als Planarisierungsschicht, ermöglichen.

Das Trägerelement und das organische strahlungsemittierende Bauelement können beispielsweise getrennt voneinander herstellbar sein und mithilfe der Zwischenschicht aufeinander aufgebracht und somit zusammengefügt werden.

Das organische elektronische Bauelement kann insbesondere eine organische, strahlungsemittierende Diode (OLED) umfassen oder als solche ausgeführt sein. Bei einer OLED können im aktiven Bereich Elektronen und Löcher unter Erzeugung der elektromagnetischen Strahlung rekombinieren.

Insbesondere kann das organische strahlungsemittierende Bauelement beispielsweise ein Substrat aufweisen. Auf dem Substrat kann die erste Elektrode aufgebracht und angeordnet sein. Über der ersten Elektrode kann die organische Schichtenfolge umfassend zumindest eine organische funktionelle Schicht oder eine Mehrzahl von funktionellen Schichten aus organischen Materialien aufgebracht sein. Die zumindest eine organische funktionelle Schicht oder die Mehrzahl der funktionellen Schichten können dabei beispielsweise eine oder mehrere Elektronentransportschichten, elektrolumineszierende Schichten, Lochtransportschichten, Elektronenblockierschichten und/oder Lochblockierschichten aufweisen oder als solche ausgeführt sein. Über der organischen Schichtenfolge kann die zweite Elektrode aufgebracht sein.

Beispielsweise kann das Substrat Glas, Quarz, eine Kunststofffolie, Metall, eine Metallfolie, einen Siliziumwafer oder ein anderes geeignetes Substratmaterial umfassen oder daraus sein. Das Substrat ist dabei transparent ausgeführt und kann starr oder flexibel sein. Insbesondere ein flexibles Substrat kann ein flexibles organisches strahlungsemittierendes Bauelement ermöglichen, das unabhängig von der Form des Trägerelements in technisch einfacher Weise auf dieses aufgebracht und auf diesem angeordnet werden kann.

Das organische strahlungsemittierende Bauelement kann mit dem Substrat unmittelbar oder wie oben beschrieben über eine Zwischenschicht mittelbar auf dem Trägerelement angeordnet sein. Das kann bedeuten, dass das Substrat zwischen dem Trägerelement und der organischen Schichtenfolge angeordnet ist. Weiterhin kann das organische strahlungsemittierende Bauelement mit einer vom Substrat abgewandten Oberfläche unmittelbar oder mittelbar auf dem Trägerelement angeordnet sein. Das kann bedeuten, dass die organische Schichtenfolge zwischen dem Substrat und dem Trägerelement angeordnet ist. Eine dem Trägerelement abgewandte Hauptoberfläche des Substrats kann dabei die Strahlungsaustrittsfläche der strahlungsemittierenden Anordnung bilden.

Weiterhin kann auch das Trägerelement als Substrat ausgebildet sein. Das kann bedeuten, dass auf dem Trägerelement unmittelbar oder über eine Zwischenschicht mittelbar die erste Elektrode, die organische Schichtenfolge und die zweite Elektrode ohne zusätzliches Substrat angeordnet sind.

Die zumindest teilweise transparente erste Elektrode kann als Anode ausgeführt sein kann und somit als Löcher-injizierendes Material dienen. die zumindest teilweise transparente zweite Elektrode kann als Kathode ausgeführt sein und somit als Elektronen-injizierendes Material dienen. Alternativ können auch die erste Elektrode als Kathode und die zweite Elektrode als Anode ausgeführt sein.

Die erste und/oder die zweite Elektrode kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise dotierte Zinkoxidverbindungen, etwa Aluminium-dotiertes Zinkoxid, oder Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Alternativ oder zusätzlich kann die erste und/oder die zweite Elektrode ein Metall wie etwa Aluminium, Barium, Indium, Silber, Gold, Magnesium, Kupfer, Kalzium oder Lithium oder Verbindungen, Kombinationen und Legierungen daraus aufweisen oder daraus sein. Insbesondere kann die erste Elektrode beziehungsweise die zweite Elektrode eine Schicht mit einem oder mehreren der vorgenannten Materialien eine Dicke von weniger als 100 nm, insbesondere von weniger als 50 nm und besonders bevorzugt kleiner oder gleich 30 nm aufweisen. Dabei ist die erste und/oder die zweite Elektrode umso durchlässiger für elektromagnetische Strahlung, je geringer die Dicke ist.

Alternativ oder zusätzlich kann die erste und/oder die zweite Elektrode ein elektrisch leitendes organisches Material wie etwa PEDOT oder Kohlenstoffnanoröhrchen aufweisen.

Beispielsweise kann die erste Elektrode und/oder die zweite Elektrode auch einen Schichtenstapel mit einer Mehrzahl von Schichten aus den oben genannten Materialien aufweisen. Der Schichtenstapel kann beispielsweise eine Metallschicht zwischen zwei TCO-Schichten aufweisen.

Weiterhin kann die erste Elektrode und/oder die zweite Elektrode zusätzlich eine als Leiterbahnen oder als Gitter strukturierte elektrisch leitende Schicht, etwa eine derart strukturierte Metallschicht, mit einer Dicke von bis zu einigen Mikrometern aufweisen, um die Querleitfähigkeit bei einer großflächigen ersten und/oder zweiten Elektrode zu erhöhen ohne die Transparenz wesentlich zu verringern.

Die organische funktionelle Schicht oder die Mehrzahl davon können organische Polymere, organische Oligomere, organische Monomere, organische kleine, nicht-polymere Moleküle ("small molecules") oder Kombinationen daraus aufweisen. Insbesondere kann es vorteilhaft sein, wenn das organische strahlungsemittierende Bauelement eine funktionelle Schicht aufweist, die als Lochtransportschicht ausgeführt ist, um eine effektive Löcherinjektion in eine als aktiven Bereich ausgeführte elektrolumineszierende Schicht oder einen elektrolumineszierenden Bereich zu ermöglichen. Abhängig von den Materialien in den funktionellen Schichten kann die im aktiven Bereich erzeugte elektromagnetische Strahlung einzelne Wellenlängen oder Bereiche oder Kombinationen daraus aus dem blauen bis roten Spektralbereich aufweisen. Insbesondere kann die elektromagnetische Strahlung auch einen mischfarbigen, etwa einen weißfarbigen, Leuchteindruck erwecken. Weiterhin kann das organische strahlungsemittierende Bauelement eine veränderliche Farbabstrahlung ermöglichen, die mittels Spannung, Strom, Temperatur, Feuchtigkeit, Druck oder einer Kombination daraus variierbar ist.

Die erste und/oder die zweite Elektrode können jeweils großflächig ausgebildet sein. Dadurch kann eine großflächige Abstrahlung der im aktiven Bereich erzeugten elektromagnetischen Strahlung ermöglicht werden. "Großflächig" kann dabei bedeuten, dass das organische strahlungsemittierende Bauelement eine Fläche von größer oder gleich einigen Quadratmillimetern, bevorzugt größer oder gleich einem Quadratzentimeter und besonders bevorzugt größer oder gleich einem Quadratdezimeter aufweist. Alternativ oder zusätzlich können die erste und/oder die zweite Elektrode zumindest in Teilbereichen strukturiert ausgebildet sein. Dadurch kann eine strukturierte Abstrahlung der im aktiven Bereich erzeugten elektromagnetischen Strahlung ermöglicht werden, etwa in Form von Pixeln oder Piktogrammen.

Darüber hinaus kann das organische strahlungsemittierende Bauelement eine transparente Verkapselung aufweisen, um beispielsweise für die erste und zweite Elektrode und die organische Schichtenfolge einen Schutz vor Feuchtigkeit und/oder oxidierenden Substanzen wie etwa Sauerstoff zu erreichen. Die Verkapselung kann dabei eine oder mehrere Schichten umfassen, wobei die Schichten der Verkapselung beispielsweise Planarisierungsschichten, Barriereschichten, Wasser und/oder Sauerstoff absorbierende Schichten, Verbindungsschichten oder Kombinationen daraus sein können. Die Verkapselung kann beispielsweise eine Abdeckung in Form einer Kappe, insbesondere einer freitragenden Kappe, und/oder eine Schicht oder Schichtenfolge in Form einer Dünnfilmverkapselung auf beziehungsweise über den Elektroden und der organischen Schichtenfolge aufweisen. Geeignete Materialien können beispielsweise Glas, Kunststoffe, Metalle, Metalloxide, Nicht-Metall-Oxide oder Nicht-Metall-Nitride wie etwa SiOₓ oder SiNₓ, Keramiken oder Kombinationen daraus aufweisen oder sein. Die Verkapselung kann dabei beispielsweise Barriereschichten und/oder Planarisierungsschichten aufweisen. Weiterhin kann die Abdeckung auch als Laminat ausgeführt sein.

Die Verkapselung kann die erste und zweite Elektrode sowie die organische Schichtenfolge gänzlich umgeben und umschließen. Weiterhin kann die Verkapselung auch das oben beschriebene Substrat umfassen, so dass ein Teil der Verkapselung auch durch das Substrat gebildet werden kann. Insbesondere kann die Verkapselung auch die Strahlungsaustrittsfläche der strahlungsemittierenden Anordnung bilden.

Das organische strahlungsemittierende Bauelement kann weiterhin mit der Verkapselung unmittelbar oder über eine Zwischenschicht mittelbar auf dem Trägerelement angeordnet sein.

Zusätzlich kann innerhalb der Verkapselung ein Gettermaterial aufgebracht sein. Als Gettermaterial kann vorzugsweise ein oxidierbares Material eingesetzt werden, welches mit Sauerstoff und Feuchtigkeit reagieren und diese Schadstoffe dabei binden kann. Als leicht oxidierende Materialien werden insbesondere Metalle aus der Gruppe der Alkali- und Erdalkali-Metalle eingesetzt. Beispielsweise kann das Gettermaterial Magnesium, Calcium, Barium und/oder Cäsium aufweisen. Weiterhin können auch andere Metalle, wie beispielsweise Aluminium, Zirkonium, Tantal, und/oder Titan oder oxidierbare nichtmetallische Materialien geeignet sein. Darüber hinaus kann das Gettermaterial Materialien aus der Zeolithgruppe und/oder Silikagel aufweisen.

Das Gettermaterial kann beispielsweise transparent ausgeführt sein, beispielsweise durch eine derart geringe Dicke, dass das Gettermaterial zumindest teilweise transparent für die im aktiven Bereich der organischen Schichtenfolge erzeugte elektromagnetische Strahlung ist. Dabei kann das Gettermaterial beispielsweise zwischen der Strahlungsaustrittsfläche der strahlungsemittierenden Anordnung und dem Trägerelement angeordnet sein, so dass die zumindest teilweise nicht-transparente Hauptoberfläche des Trägerelements durch das Gettermaterial hindurch zumindest in einem ausgeschalteten Betriebszustand des organischen strahlungsemittierenden Bauelements wahrnehmbar ist. Alternativ oder zusätzlich kann das Gettermaterial auch lateral versetzt zur Strahlungsaustrittsfläche angeordnet sein, so dass das Gettermaterial bezüglich der Betrachtungsrichtung eines externen Beobachters nicht zischen der Strahlungsaustrittsfläche und der zumindest teilweise nicht-transparenten Hauptoberfläche des Trägerelements angeordnet ist. In diesem Fall kann das Gettermaterial auch nicht-transparent ausgeführt sein.

Das organische strahlungsemittierende Bauelement kann weiterhin als optische Kavität für die im aktiven Bereich erzeugte elektromagnetische Strahlung ausgebildet sein. Eine "optische Kavität" kann dabei hier und im Folgenden insbesondere bedeuten, dass das organische strahlungsemittierende Bauelement einen optischen Resonator bildet, in dem elektromagnetische Strahlung mit einer oder mehreren bestimmten Wellenlängen und/oder einer oder mehreren bestimmten Abstrahlrichtungen bevorzugt erzeugt werden kann, die auch als Resonanzen oder Moden bezeichnet werden können. Dazu können beispielsweise die erste Elektrode, die organische Schichtenfolge und die zweite Elektrode als optische Kavität ausgebildet sein. Das kann bedeuten, dass die zumindest teilweise transparente erste Elektrode und die zumindest teilweise transparente zweite Elektrode zusätzlich auch eine Reflektivität für die im aktiven Bereich erzeugte elektromagnetische Strahlung aufweisen. Alternativ oder zusätzlich können die erste Elektrode, die organische Schichtenfolge und die zweite Elektrode zwischen teilweise reflektierenden Schichten angeordnet sein, die zusätzlich auch teilweise transparent sind. Die folgende Beschreibung der optischen Kavität ist rein beispielhaft für teilweise reflektierende Elektroden ausgeführt und lässt sich für den Fachmann auf alternative Ausgestaltungen übertragen.

Die erste Elektrode und/oder die zweite Elektrode können einen Reflexionsgrad R beziehungsweise R' aufweisen und die organische Schichtenfolge kann einen Brechungsindex n für die elektromagnetische Strahlung aufweisen. Da die erste und zweite Elektrode teilweise transparent sind, gilt dabei R<1 und R'<1. Der Brechungsindex n kann über die organische Schichtenfolge konstant sein oder zumindest in Teilbereichen, beispielsweise in verschiedenen funktionellen Schichten, konstant sein. Weiterhin kann der Brechungsindex n auch über die organische Schichtenfolge variieren. Der aktive Bereich der organischen Schichtenfolge kann eine Dicke d aufweisen und mit einem mittleren Abstand L von der ersten Elektrode und mit einem mittleren Abstand L' von der zweiten Elektrode beabstandet angeordnet sein. Der mittlere Abstand L und der mittlere Abstand L' bezeichnen dabei die über die Dicke d des aktiven Bereichs gemittelten Abstände zur ersten Elektrode beziehungsweise zur zweiten Elektrode. Dabei können die Parameter R, R', n, d, L und L' derart gewählt sein, dass die organische Schichtenfolge eine bestimmte Abstrahlcharakteristik aufweist. Beispielsweise können die Reflexionsgrade R und R' der ersten und zweiten Elektrode und der Brechungsindex n der organischen Schichtenfolge aufgrund der jeweiligen Materialwahl vorgegeben sein, so dass durch Wahl der mittleren Abstände L und L' und der Dicke d des aktiven Bereichs die gewünschte Abstrahlcharakteristik ermöglicht werden kann. Alternativ dazu können die Abmessungen der organischen Schichtenfolge und des aktiven Bereichs, also die mittleren Abstände L und L' und die Dicke d, vorgegeben sein, beispielsweise durch den Aufbau oder das Herstellungsverfahren des organischen strahlungsemittierenden Bauelements. In diesem Fall kann durch Wahl des Materials für die erste und zweite Elektrode über deren Reflexionsgrad R und R' die gewünschte Abstrahlcharakteristik ermöglicht werden.

Beispielsweise können die mittleren Abstände L und L' in der Größenordnung der Wellenlänge der im aktiven Bereich erzeugten elektromagnetischen Strahlung oder kleiner sein. Weist die elektromagnetische Strahlung eine spektrale Verteilung von mehreren Wellenlängen und/oder Wellenlängenbereichen auf, kann die elektromagnetische Strahlung dabei auch durch eine mittlere Wellenlänge charakterisiert werden und die Abmessungen der organischen Schichtenfolge hier und im folgenden auf die mittlere Wellenlänge der elektromagnetischen Strahlung bezogen sein. Weiterhin können die mittleren Abstände auch kleiner oder gleich der halben Wellenlänge der elektromagnetischen Strahlung sein oder kleiner oder gleich einem Viertel der Wellenlänge der elektromagnetischen Strahlung oder auch kleiner oder gleich einem Achtel der Wellenlänge der elektromagnetischen Strahlung sein. Weiterhin oder zusätzlich können die mittleren Abstände L und L' größer oder gleich 1/20 der Wellenlänge der elektromagnetischen Strahlung sein oder auch größer oder gleich 1/10.

Solche mittleren Abstände L und L' können in Verbindung mit der teilweise reflektierenden ersten und zweiten Elektrode die Ausbildung einer zumindest halbseitig reflektierenden Kavität in der strahlungsemittierenden Schichtenfolge bewirken. Ein von einem angeregten Zustand (Exciton) im aktiven Bereich abgestrahltes Photon bzw. Wellenpaket kann dabei an der ersten Elektrode und an der zweiten Elektrode reflektiert werden. Dadurch, dass die mittleren Abstände L und L' in der Größenordnung der Wellenlänge der elektromagnetischen Strahlung oder kleiner sein können, kann, vereinfacht gesprochen, eine Rückkopplung des abgestrahlten Wellenpakets mit dem angeregten Zustand noch während der Abstrahlung des Wellenpakets möglich sein, so dass der angeregte Zustand während der Abstrahlung des Wellenpakets vom elektromagnetischen Feld seines "eigenen" reflektierten Wellenpakets beeinflusst werden kann. Je nach Phasenlage des reflektierten Wellenpakets kann somit eine Verstärkung oder Abschwächung der Abstrahlung des angeregten Zustands ermöglicht werden. Die Phasenlage kann dabei vom Brechungsindex der organischen Schichtenfolge, den Reflektivitäten der ersten und zweiten Elektrode in Verbindung mit der Eindringtiefe der elektromagnetischen Strahlung in die erste und zweite Elektrode sowie von den Abständen zwischen dem angeregten Zustand und der ersten und zweiten Elektrode in Verbindung mit der Abstrahlrichtung des Wellenpakets abhängig sein. Dadurch kann sich in der organischen Schichtenfolge eine Modenstruktur ausbilden, die eine Abstrahlung der elektromagnetischen Strahlung in bestimmte Richtungen begünstigen und/oder bewirken kann. Weiterhin kann auch die Dicke des aktiven Bereichs die Ausbildung von Abstrahlungsmoden beeinflussen.

Das organische Bauelement weist eine Abstrahlcharakteristik der im aktiven Bereich erzeugten elektromagnetischen Strahlung auf, so dass in Richtung des Trägerelements die elektromagnetische Strahlung mit einer ersten Intensität und in Richtung der Strahlungsaustrittsfläche mit einer zweiten Intensität abgestrahlt wird. Die erste Intensität und die zweite Intensität können dabei an Außenflächen des organischen strahlungsemittierenden Bauelements definiert sein, also beispielsweise an von der organischen Schichtenfolge abgewandten Oberflächen der ersten oder zweiten Elektrode, eines Substrats oder einer Verkapselung. Dabei kann die zweite Intensität auch an der Strahlungsaustrittsfläche der strahlungsemittierenden Anordnung definiert sein. Mit "Intensität in Richtung" des Trägerelements beziehungsweise der Strahlungsaustrittsfläche kann für die erste und zweite Intensität die jeweilige Gesamtintensität in die Halbräume auf der dem Trägerelement zugewandten beziehungsweise abgewandten Seite des organischen strahlungsemittierenden Bauelements bezeichnet sein.

Die elektromagnetische Strahlung mit der ersten Intensität, die in Richtung des Trägerelements vom organischen strahlungsemittierenden Bauelement abgestrahlt wird, beleuchtet dabei die zumindest teilweise nicht-transparente Hauptoberfläche des Trägerelements. Dadurch, dass die Hauptoberfläche zumindest teilweise nicht-transparent ist, wird zumindest ein Teil der elektromagnetischen Strahlung mit der ersten Intensität in Richtung der Strahlungsaustrittsfläche reflektiert und ist durch die Strahlungsaustrittsfläche hindurch von einem externen Beobachter wahrnehmbar. Mit anderen Worten bedeutet das, dass für einen externen Beobachter die zumindest teilweise nicht-transparente Hauptoberfläche des Trägerelements beleuchtet und damit in einem eingeschalteten Betriebszustand des organischen strahlungsemittierenden Bauelements wahrnehmbar ist. Dies ist genau dann der Fall, wenn die erste Intensität größer als die zweite Intensität ist.

Eine derartige Abstrahlcharakteristik kann dabei beispielsweise durch eine optische Kavität wie oben beschrieben ermöglicht werden. Alternativ oder zusätzlich können die erste und zweite Elektrode voneinander verschiedene Durchlässigkeiten, also Transmittivitäten, aufweisen. Ist etwa die erste Elektrode auf der dem Trägerelement zugewandten Seite der organischen Schichtenfolge angeordnet und weist eine größere Transmittivität als die zweite Elektrode auf, kann es möglich sein, dass die im aktiven Bereich erzeugte elektromagnetische Strahlung mit einer ersten Intensität in Richtung des Trägerelements abgestrahlt wird, die größer als die zweite Intensität ist.

Das organische strahlungsemittierende Bauelement und die Strahlungsaustrittsfläche erscheinen im ausgeschalteten Betriebszustand durchsichtig und im eingeschalteten Betriebszustand ebenfalls zumindest teilweise durchsichtig. Das organische strahlungsemittierende Bauelement kann beispielsweise derart strukturiert ausgebildet sein, dass im eingeschalteten Betriebszustand des organischen strahlungsemittierenden Bauelements durch erste Bereiche der Strahlungsaustrittsfläche hindurch die zumindest teilweise nicht-transparente Hauptoberfläche wahrnehmbar ist und durch zweite Bereiche hindurch nicht. Dabei kann das organische strahlungsemittierende Bauelement beispielsweise nur in Teilbereichen elektromagnetische Strahlung abstrahlen oder auch großflächig elektromagnetische Strahlung abstrahlen. Durch ein derartiges segmentiertes Ausleuchten der Hauptoberfläche und/oder ein segmentiertes Abstrahlen der elektromagnetischen Strahlung in Richtung eines externen Beobachters kann es möglich sein, dass sich beispielsweise verschiedene Beleuchtungsmuster erzeugen oder temporär Hinweise oder Informationen einblenden lassen. Im ausgeschalteten Betriebszustand sind diese Muster, Hinweise und/oder Informationen nicht sichtbar und beinträchtigen die Erscheinungsform und die Wahrnehmbarkeit der zumindest teilweise nicht-transparenten Hauptoberfläche nicht.

Weiterhin kann die strahlungsemittierende Anordnung eine Filterschicht aufweisen, die auf der dem organisches strahlungsemittierenden Bauelement zugewandten Seite des Trägerelements angeordnet ist. Die Filterschicht kann dabei zwischen dem organischen strahlungsemittierenden Bauelement und dem Trägerelement oder zwischen dem organischen strahlungsemittierenden Bauelement und der Strahlungsaustrittsfläche angeordnet sein. Im letzteren Fall kann die Filterschicht auch die Strahlungsaustrittsfläche der strahlungsemittierenden Anordnung bilden.

Die Filterschicht kann einen wellenlängenabhängigen und/oder einen intensitätsabhängigen Transmissionskoeffizienten aufweisen. Beispielsweise kann die Filterschicht einen absorbierenden Farbstoff, eine Wellenlängenkonversionsstoff, ein sättigbares Absorbermaterial oder eine Kombination daraus aufweisen. Weiterhin kann die Filterschicht beispielsweise einen spannungsabhängigen Transmissionskoeffizienten aufweisen. Dazu kann die Filterschicht ein spannungsabhängig absorbierendes und/oder spannungsabhängig streuendes Material, etwa ein elektrochromes Material oder Flüssigkristalle in einer Polymermatrix, aufweisen, die zwischen zwei transparenten Elektroden, etwa aus einem TCO, angeordnet ist. Die Filterschicht kann dabei beispielsweise als so genanntes "smart glass" ausgeführt sein.

Die Filterschicht kann zusätzlich auch strukturiert sein und in verschiedenen Teilbereichen verschiedene Funktionalitäten aufweisen. Durch die Filterschicht kann die Erscheinungsform der zumindest teilweise nicht-transparenten Hauptoberfläche im eingeschalteten und/oder im ausgeschalteten Betriebszustand des organischen strahlungsemittierenden Bauelements modifizierbar und veränderbar sein.

Weitere Vorteile und vorteilhafte Ausführungsformen und Weiterbildungen der Erfindung ergeben sich aus den im Folgenden in Verbindung mit den Figuren 1A bis 8B beschriebenen Ausführungsformen.

Es zeigen:
Figuren 1A und 1B schematische Schnittdarstellungen einer strahlungsemittierenden Anordnung gemäß einem Ausführungsbeispiel,
Figuren 2 bis 6 schematische Schnittdarstellungen von strahlungsemittierenden Anordnungen gemäß weiteren Ausführungsbeispielen und
Figuren 7A bis 8B schematische Draufsichten von strahlungsemittierenden Anordnungen gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

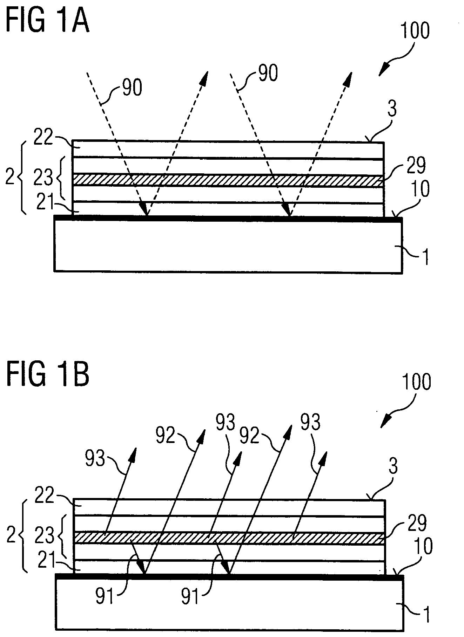

In den Figuren 1A und 1B ist ein Ausführungsbeispiel für eine strahlungsemittierende Anordnung 100 gezeigt. Dabei zeigt Figur 1A einen ausgeschalteten Betriebszustand, während Figur 1B einen eingeschalteten Betriebszustand zeigt. Die nachfolgende Beschreibung bezieht sich, soweit nicht anders gekennzeichnet, gleichermaßen auf die Figuren 1A und 1B.

Die strahlungsemittierende Anordnung 100 weist ein Trägerelement 1 auf, auf dem ein organisches strahlungsemittierendes Bauelement 2 angeordnet ist.

Das Trägerelement 1 weist eine zumindest teilweise nicht-transparente Hauptoberfläche 10 auf, auf der das organische strahlungsemittierende Bauelement 2 angeordnet ist. Im gezeigten Ausführungsbeispiel ist das Trägerelement 1 rein exemplarisch aus einem farbigen, nicht-transparenten Kunststoff und kann beispielsweise Teil einer Dekorplatte oder einer Kachel oder Fließe sein. Die Hauptoberfläche 10 ist dabei ebenfalls farbig und nicht-transparent. Dabei weist die Hauptoberfläche 10 im gezeigten Ausführungsbeispiel eine künstlerisch gestaltete Farbstruktur auf, die unterschiedliche spektrale Anteile des Tageslichts beziehungsweise des Umgebungslichts, angedeutet durch die elektromagnetische Strahlung 90 in Figur 1A, reflektieren kann. Die Farbstruktur der Hauptoberfläche 10 ist der Übersichtlichkeit in den Figuren 1A und 1B nicht gezeigt.

Durch eine Strahlungsaustrittsfläche 3 der strahlungsemittierenden Anordnung 100 hindurch, die einem möglichen externen Beobachter zugewandt ist, ist die zumindest teilweise nicht-transparente Hauptoberfläche 10 für den externen Beobachter im ausgeschalteten Betriebszustand des organischen strahlungsemittierenden Bauelements 2 gemäß Figur 1A wahrnehmbar. Das Trägerelement 1 kann dazu wie oben beschrieben in Form einer Dekorplatte, Fließe oder Kachel an einer Wand, beispielsweise an einer Innenwand, befestigt sein oder als Teil der Wand ausgeführt sein.

Das organisches strahlungsemittierende Bauelement 2 weist eine erste Elektrode 21 auf dem Trägerelement 1 auf, auf der eine organisches Schichtenfolge 23 und darüber eine zweite Elektrode 22 angeordnet sind. Die erste Elektrode 21 und die zweite Elektrode 22 sind dabei zumindest teilweise transparent, so dass, wie in Figur 1A gezeigt, zumindest ein Teil des Umgebungslichts 90 das organische strahlungsemittierende Bauelement 2 durchqueren kann und an der Hauptoberfläche 10 in Richtung zur Strahlungsaustrittsfläche 3 reflektiert werden kann, wodurch sich die oben beschriebene Wahrnehmbarkeit der Hauptoberfläche 10 für einen externen Beobachter ergibt. die Strahlungsaustrittsfläche 3 wird im gezeigten Ausführungsbeispiel durch die der organischen Schichtenfolge 23 abgewandte Oberfläche der zweiten Elektrode 22 gebildet.

Die organische Schichtenfolge 23 zwischen der zumindest teilweise transparenten ersten Elektrode 21 und der zumindest teilweise transparenten zweiten Elektrode 22 weist einen aktiven Bereich 29 auf, der in einem eingeschalteten Betriebszustand gemäß Figur 1B elektromagnetische Strahlung 91, 93 erzeugen kann. Das organische strahlungsemittierende Bauelement 2 ist als organische, lichtemittierende Diode (OLED) ausgeführt und weist, wie im allgemeinen Teil beschrieben, funktionelle Schichten zum Löcher- und Elektronentransport sowie eine als aktiven Bereich 29 ausgeführte elektrolumineszierende Schicht auf. Die elektromagnetische Strahlung 91, 93 erweckt im gezeigten Ausführungsbeispiel einen weißfarbigen Leuchteindruck.

Das Trägerelement 1 weist eine geeignete elektrische Ansteuereinheit zur Spannungs- und Stromversorgung des organischen strahlungsemittierenden Bauelements 2 aufweisen, das über elektrische Kontakte oder Kontaktbahnen als Verlängerungen zu den Elektroden 21 und 22 angeschlossen ist (nicht gezeigt). Der aktive Bereich 29 und die elektrische Ansteuereinheit können auch derart ausgeführt sein, dass die vom aktiven Bereich 29 erzeugte elektromagnetische Strahlung 91, 93 dimmbar und/oder hinsichtlich der Farbtemperatur oder des Farbeindrucks veränderbar ist. Derartige Ausgestaltungen sind dem Fachmann bekannt und werden hier nicht näher ausgeführt. Weiterhin ist die Größe der Leuchtfläche, also der Strahlungsaustrittsfläche 3, frei und für den Fachmann auf bekannte Art und Weise unter Gesichtspunkten wie Effizienz und Stromverbrauch frei wählbar.

Die vom aktiven Bereich 29 erzeugte elektromagnetische Strahlung wird dabei mit einer ersten Intensität in Richtung der Hauptoberfläche 10 des Trägerelements 1 abgestrahlt, wie durch die elektromagnetische Strahlung 91 angedeutet ist. Zumindest ein Teil davon, angedeutet durch die elektromagnetische Strahlung 92, wird zur Strahlungsaustrittsfläche 3 reflektiert und kann von einem externen Beobachter wahrgenommen werden. Der externe Beobachter kann dadurch den Sinneseindruck einer beleuchteten Hauptoberfläche 10 haben.

Die vom aktiven Bereich 29 erzeugte elektromagnetische Strahlung wird weiterhin mit einer zweiten Intensität in Richtung der Strahlungsaustrittsfläche 3 abgestrahlt, wie durch die elektromagnetische Strahlung 93 angedeutet ist. Das relative Verhältnis von erster und zweiter Intensität zueinander wird wie im allgemeinen Teil beschrieben durch eine optische Kavität oder auch durch verschieden transparente erste und zweite Elektrode 21, 22 so eingestellt oder gewählt, dass die erste Intensität größer ist als die zweite Intensität.

Zusätzlich zur elektromagnetischen Strahlung 92 und/oder 93 kann es im Prinzip auch möglich sein, dass der externe Beobachter auch das in Figur 1A gezeigte Umgebungslicht 90, das an der Hauptoberfläche 10 reflektiert wird, wahrnimmt.

Jedoch kann es auch möglich sein, dass das an der Hauptoberfläche 10 reflektierte Umgebungslicht 90 durch die vom aktiven Bereich erzeugte und von der Hauptoberfläche 10 reflektierte elektromagnetische Strahlung 92 überstrahlt wird, so dass ein externer Beobachter das reflektierte Umgebungslicht 90 im oben beschriebenen Sinne nicht wahrnehmen kann.

Durch die transparente Ausführung des organischen strahlungsemittierenden Bauelements 2 erscheint die dahinter liegende Hauptoberfläche 10 des Trägerelements 1 im ausgeschalteten Betriebszustand in seiner ursprünglichen Form und Farbe und behält somit für einen externen Beobachter den Eindruck seiner charakteristischen Materialeigenschaften bei. Je nach Einstellung des Emissionsverhältnisses zwischen vorder- und rückseitiger Emission, also der Abstrahlung zur Strahlungsaustrittsfläche 3 hin mit der zweiten Intensität beziehungsweise zum Trägerelement 1 hin mit der ersten Intensität, lassen sich im eingeschalteten Betriebszustand verschiedene Wirkungen erzielen. Erfolgt die Abstrahlung überwiegend in Richtung des Trägerelements 1, ist also die zweite Intensität kleiner als die erste Intensität, so erreicht man hierdurch eine effektive, raumsparende Beleuchtung des dahinter liegenden Materials und damit der Hauptoberfläche 10. Durch die Wahl der Beleuchtungsstärke lassen sich Materialeigenschaften gezielt hervorheben, da durch das transparente organische strahlungsemittierende Bauelement 2 hindurch das dahinter liegende Material auch im angeschalteten Zustand betrachtet werden kann.

Durch geeignete Wahl der Wellenlänge, der Intensität und der Abstrahlrichtung der elektromagnetische Strahlung 91, 93 kann somit die Erscheinungsform der Hauptoberfläche 10 im eingeschalteten Betriebszustand des organischen strahlungsemittierenden Bauelements beeinflusst werden und beispielsweise die Farbstruktur der Hauptoberfläche 10 vorteilhaft hervorgehoben werden.

Das Trägerelement 1 kann auch alternativ zum gezeigten Ausführungsbeispiel eine Mehrzahl von organischen strahlungsemittierenden Bauelementen aufweisen, die nebeneinander oder übereinander parallel oder in Serie oder unabhängig voneinander elektrisch angeschlossen sein können. Die gesamte Hauptoberfläche 10 des Trägerelements 1 kann dabei als Trägerfläche für eines oder mehrere organische strahlungsemittierende Bauelement dienen, wobei die Form der Strahlungsaustrittsfläche 3 frei wählbar ist. Das Trägerelement 1 kann dabei auch als segmentierte Leuchtkachel ausgeführt sein.

In den folgenden Figuren sind Modifikationen und Variationen des in den Figuren 1A und 1B gezeigten Ausführungsbeispiels gezeigt. Die nachfolgende Beschreibung bezieht sich daher hauptsächlich auf die Unterschiede und Weiterbildungen im Vergleich zum vorangegangenen Ausführungsbeispiel.

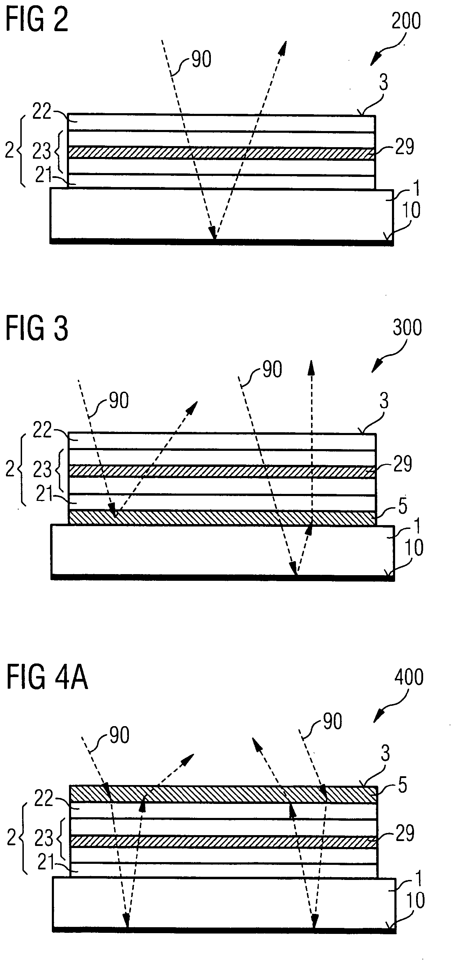

In Figur 2 ist ein Ausführungsbeispiel für eine strahlungsemittierende Anordnung 200 gezeigt, bei der die zumindest teilweise nicht-transparente Hauptoberfläche 10 vom organischen strahlungsemittierenden Bauelement 2 abgewandt angeordnet ist. Das Trägerelement 1 weist dazu auf der dem organischen strahlungsemittierenden Bauelement 2 zugewandten Seite der Hauptoberfläche 10 ein transparentes Material auf. Im gezeigten Ausführungsbeispiel ist das Trägerelement 1 aus Glas, das als zumindest teilweise nicht-transparente Hauptoberfläche 10 eine nicht-transparente Beschichtung aus einem Lack aufweist. Die Beschichtung kann dabei vor oder auch dem Aufbringen des organischen strahlungsemittierenden Bauelements 2 auf dem Trägerelement 1 aufgebracht werden.

In Figur 3 ist ein Ausführungsbeispiel für eine strahlungsemittierende Anordnung 300 gezeigt, bei dem zwischen dem Trägerelement 1 und dem organischen strahlungsemittierenden Bauelement 2 eine intensitäts- und wellenlängenabhängige Filterschicht 5 angeordnet ist. Die Filterschicht 5 ist teilweise transparent mit einem sättigbaren Wellenlängenkonversionsstoff ausgeführt. In einem ausgeschalteten Betriebszustand wird dabei ein Teil des Umgebungslichts 90 von der Filterschicht 5 absorbiert und in eine andere Wellenlänge konvertiert und gestreut, so dass die Hauptoberfläche 10 des Trägerelements 1 farbig erscheint und ein Milchglas-artiger Betrachtungseindruck bei einem externen Beobachter erweckt werden kann.

In einem eingeschalteten Betriebszustand (nicht gezeigt) ist die erste Intensität, also die Intensität der elektromagnetische Strahlung, die im aktiven Bereich 29 erzeugt und in Richtung des Trägerelements 1 abgestrahlt wird, groß genug, um die Filterschicht 5 zu sättigen, so dass der überwiegende Teil der elektromagnetischen Strahlung mit der ersten Intensität dazu dient, die Hauptoberfläche 10 bei einem externen Beobachter direkt wahrnehmbar und ohne den farbigen Eindruck der Filterschicht 5 abzubilden. Die vom aktiven Beriech 29 erzeugte elektromagnetische Strahlung erweckt dabei einen weißfarbigen Leuchteindruck. Die zumindest teilweise nicht-transparente Hauptoberfläche 10 kann somit im eingeschalteten Betriebszustand klar und deutlich und ohne Verfärbung wahrnehmbar sein.

Alternativ zum hier gezeigten Ausführungsbeispiel kann die Filterschicht 5 auch auf der dem Trägerelement 1 abgewandten Seite des organischen strahlungsemittierenden Bauelements 2 angeordnet sein, so dass die Filterschicht 5 die Strahlungsaustrittsfläche 3 bilden kann.

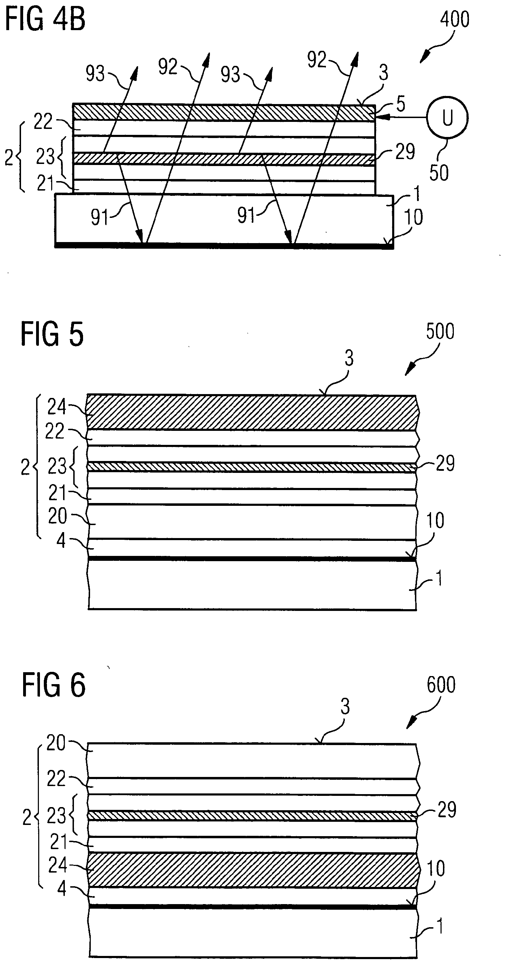

In den Figuren 4A und 4B ist ein Ausführungsbeispiel für eine strahlungsemittierende Anordnung 400 in einem ausgeschalteten Betriebszustand (Figur 4A) und in einem eingeschalteten Betriebszustand (Figur 4B) gezeigt.

Die strahlungsemittierende Anordnung 400 weist eine Filterschicht 5 auf der dem Trägerelement 1 abgewandten Seite des organischen strahlungsemittierenden Bauelements 2 auf.

Die Filterschicht 5 ist als spannungsabhängige Filterschicht mit einem spannungsabhängigen Transmissionskoeffizienten ausgebildet und weist ein Flüssigkristallmaterial in einer Polymermatrix auf. Die Polymermatrix ist zwischen zwei transparenten Elektroden aus TCO angeordnet (nicht gezeigt).

Ohne anliegende Spannung an der Filterschicht 5 sind die Flüssigkristalle in der Polymermatrix ungeordnet und können daher das Umgebungslicht streuen, wie in Figur 4A gezeigt ist. Die zumindest teilweise nicht-transparente Hauptoberfläche 10 ist dadurch durch einen Milchglas-artigen Effekt verschwommen wahrnehmbar.

Die Filterschicht 5 ist so ausgeführt, dass eine Spannung 50 im eingeschalteten Betriebszustand des organischen strahlungsemittierenden Bauelements angelegt wird, wie in Figur 4B gezeigt ist. Durch das Anlegen der Spannung 50 an die Filterschicht 5 können die Flüssigkristalle derart ausgerichtet werden, dass die vom aktiven Bereich erzeugte elektromagnetische Strahlung 93 mit der zweiten Intensität und die elektromagnetische Strahlung 92, die die von der Hauptoberfläche 10 reflektierte elektromagnetische Strahlung 91 ist, nicht gestreut werden und somit eine klare Wahrnehmung der Hauptoberfläche 10 bei einem externen Beobachter möglich ist.

In Figur 5 ist ein Ausführungsbeispiel für eine strahlungsemittierende Anordnung 500 gezeigt.

Auf dem Trägerelement 1 ist im gezeigten Ausführungsbeispiel ein organisches strahlungsemittierendes Bauelement 2 angeordnet, das ein transparentes Substrat 20 aufweist. Auf dem Substrat 20, das als flexible Kunststofffolie ausgeführt ist, sind die erste Elektrode 21, die organische Schichtenfolge 23 und die zweite Elektrode 22 aufgebracht. Darüber ist eine Verkapselung 24 angeordnet, die als mehrschichtige Dünnfilmverkapselung mit einer Mehrzahl von Barriereschichten und Planarisierungsschichten ausgebildet ist. Das organische strahlungsemittierende Bauelement 2 ist damit flexibel ausgeführt und kann alternativ zum gezeigten Ausführungsbeispiel auch auf Trägerelementen angeordnet werden, die nicht plan sind sondern beispielsweise eine Krümmung aufweisen. Die Verkapselung 24 bildet die Strahlungsaustrittsfläche 3 der strahlungsemittierenden Anordnung 500.

Weiterhin weist die strahlungsemittierende Anordnung 500 eine Zwischenschicht 4 auf, die zwischen dem Trägerelement 1 und dem organischen strahlungsemittierenden Bauelement 2 angeordnet ist. Dabei ist das Substrat 20 dem Trägerelement 1 zugewandt und mittels der Zwischenschicht 4 auf der zumindest teilweise nicht-transparenten Hauptoberfläche 10 angeordnet.

Im gezeigten Ausführungsbeispiel weist die Zwischenschicht ein transparentes Harz auf, so etwa ein Silikon- oder Epoxidharz, das zum einen die zumindest teilweise nicht-transparente Hauptoberfläche 10 planarisiert und zum anderen eine stoffschlüssige Verbindung zwischen dem Trägerelement 1 und der organischen strahlungsemittierenden Bauelement 2 schafft. Alternativ kann die Zwischenschicht 4 auch eines der oben im allgemeinen Teil genannten Materialien aufweisen.

In Figur 6 ist ein Ausführungsbeispiel für eine strahlungsemittierende Anordnung 600 gezeigt. Wie beim vorhergehenden Ausführungsbeispiel weist die strahlungsemittierende Anordnung 600 ein organisches strahlungsemittierendes Bauelement 2 mit einem Substrat 20 und einer Verkapselung 24 auf. Im Gegensatz zum vorhergehenden Ausführungsbeispiel ist bei der strahlungsemittierenden Anordnung 600 das organische strahlungsemittierende Bauelement 2 mit der Verkapselung 24 mittels der Zwischenschicht 4 auf dem Trägerelement 1 angeordnet.

Das Substrat 20 bildet die Strahlungsaustrittsfläche 3 der strahlungsemittierenden Anordnung 600 und dient gleichzeitig als Schutzschicht für das darunter liegende Trägerelement 1.

Im Hinblick auf die hier gezeigten Ausführungsbeispielen lassen sich die hier beschriebenen strahlungsemittierenden Anordnungen für eine Vielzahl von Anwendungen einsetzen. Im Folgenden sind einige weitere konkrete Anwendungen und Ausführungsbeispiele rein beispielhaft erläutert, wobei als organisches strahlungsemittierendes Bauelement 2 zumeist eine OLED angenommen wird.

Im Bereich Design ist es äußerst wünschenswert, die Aufmerksamkeit eines Beobachters beispielsweise auf bestimmte Stellen oder Oberflächen zu lenken oder manche Oberflächen und Materialien gezielt hervorzuheben. Dies kann beispielsweise für Designelemente und architektonische beziehungsweise künstlerische Aspekte durch veränderbare beziehungsweise leuchtende Oberflächen der Fall sein. es lässt sich in hervorragender Weise mit der beschriebenen Kombination von organischen strahlungsemittierenden Bauelementen 2 und dem gewünschten Objekt, Gegenstand oder Oberfläche in Form des Trägerelements 1 mit der Hauptoberfläche 10 erreichen. Dieses Prinzip lässt sich auf alle Gegenstände und Oberflächen bereits bestehender Objekte mit Oberflächen beispielsweise aus Holz, Marmor, Stein, Kunststoff etc. anwenden. Durch die Verwendung von flexiblen transparenten Substraten für die OLEDs gibt es im Prinzip keine Einschränkung auf bestimmte Oberflächenformen des Trägerelements 1. Es kann sich dabei um die Oberflächen von Schränken, Arbeitsplatten, Wänden, Decken, Treppen, Vitrinen, Bodenbelägen, von Gehäusen verschiedener Geräte, Fahrzeugen, Spielsachen, Designelementen, Fassaden von Gebäuden, etc. handeln. Im ausgeschalteten Zustand kann sich somit die natürliche Wirkung des verwendeten Materials entfalten. Im Gegensatz dazu lässt sich durch das Einschalten des Beleuchtungselements an bestimmten Stellen oder auf der gesamten Oberfläche der spezifische Materialeindruck verstärken bzw. verändern.

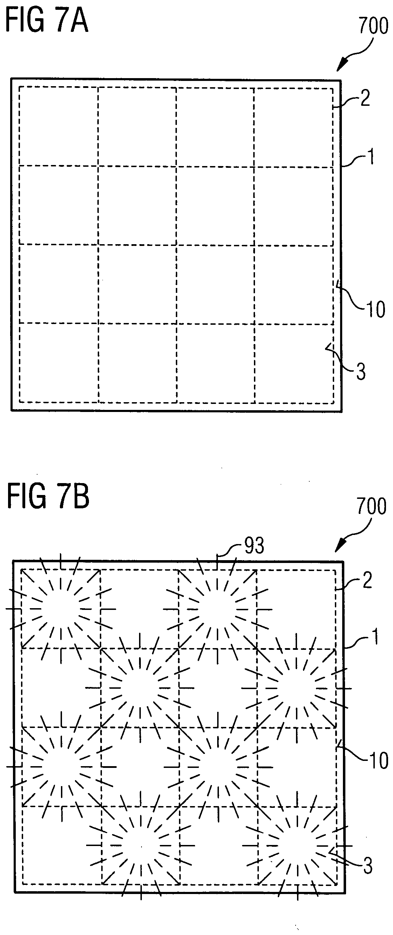

Durch ein segmentiertes Beleuchten der dahinter liegenden Hauptoberfläche 10 lassen sich auf uniformen Oberflächen im Prinzip aus dem "Nichts" Schriftzüge oder Muster abbilden. Dadurch lässt sich z.B. auf einer beliebigen Oberfläche wie z.B. einer beispielsweise schwarzen Marmorplatte oder einer stilvollen Holzplatte als Trägerelement 1 durch das Einschalten der OLED-Segmente ein Schachbrettmuster erzeugen. Dies ist im Ausführungsbeispiel einer strahlungsemittierenden Anordnung 700 gemäß der Figuren 7A in einem ausgeschalteten Betriebszustand und 7B in einem eingeschalteten Betriebszustand in einer Draufsicht gezeigt. Das organische Bauelement 2 ist dabei strukturiert ausgeführt, so dass nur in Teilbereichen der Strahlungsaustrittsfläche 3 ein Beleuchtungseindruck bei einem externen Beobachter erweckt werden kann.

In bisherigen Anwendungen müssen solche Muster bereits in die Oberfläche eingearbeitet sein. Wird beispielsweise aber ein als segmentierte, transparente OLED ausgeführtes organisches strahlungsemittierendes Bauelement 2 wie im gezeigten Ausführungsbeispiel gemäß der Figuren 7A und 7B auf einer Oberfläche eines Tisches oder eines Bodenbelages aufgebracht, so erhält man ein schaltbares Muster und damit im eingeschalteten Zustand eine zusätzliche Funktionalität.

Organische strahlungsemittierende Bauelemente 2 ausgeführt als transparente OLEDs, die auf beliebigen Oberflächen eines Raumes oder Gegenstandes als Trägerelement 1 aufgebracht sind, können auch als Beleuchtungselemente dienen. So bleibt im ausgeschalteten Zustand der OLED der ursprüngliche Eindruck der Hauptoberfläche 10 des Trägerelements 1 in gewohnter Weise erhalten, wobei im eingeschalteten Zustand der Eindruck erzeugt werden kann, dass der als Trägerelement 1 ausgeführte Gegenstand oder Raum anfängt zu leuchten. Dies kann beispielsweise dazu benutzt werden, ein angenehmes Stimmungslicht zu erzeugen. Der Eindruck wird in diesem Falle durch die Auswahl des verwendeten Untergrundmaterials sehr stark beeinflusst.

In verschiedenen Städten soll es in naher Zukunft Pflicht werden, dass beispielsweise Hausnummernschilder beleuchtet sein müssen beziehungsweise von sich aus leuchten. Dies lässt sich sehr leicht mit dem hier beschriebenen Prinzip realisieren.

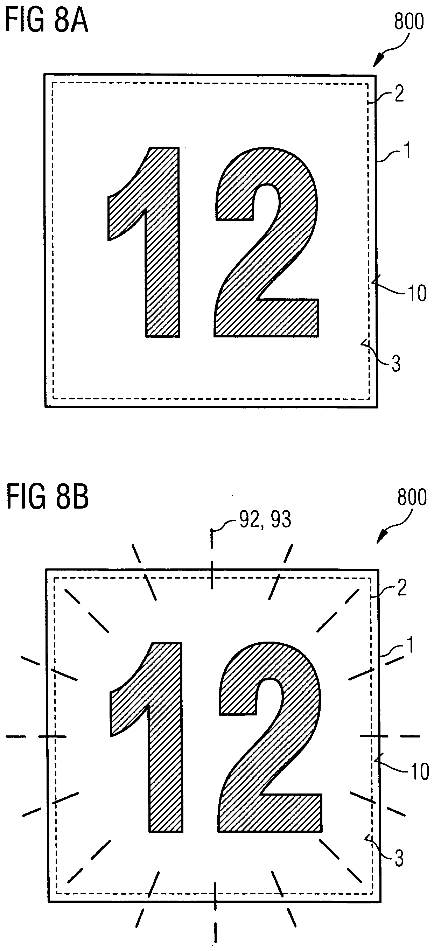

In den Figuren 8A und 8B ist ein Ausführungsbeispiel für eine strahlungsemittierende Anordnung 800 in einer Draufsicht im ausgeschalteten Betriebszustand (Figur 8A) und im eingeschalteten Betriebszustand (Figur 8B) gezeigt. In dem gezeigten Ausführungsbeispiel ist ein typisches Hausnummerschild, beispielsweise in den Farben weiß und blau, als Trägerelement 1 hinter einem als transparente OLED ausgeführten organischen strahlungsemittierenden Bauelement 2 angebracht. Dabei ist das Hausnummernschild sowohl im ausgeschalteten Betriebszustand des organischen strahlungsemittierenden Bauelements 2 eindeutig erkennbar.

Etwa bei Dunkelheit kann das Hausnummerschild auf sehr einfache Weise homogen beleuchtet werden, indem wie in Figur 8B gezeigt die Hauptoberfläche 10 durch die mittels der Strahlungsaustrittsfläche 3 abgestrahlte elektromagnetische Strahlung 92, 93 wahrnehmbar ist. Der Vorteil gegenüber selbstleuchtenden Hausnummerschildern ist, dass diese nicht speziell für jede Hausnummer einzeln hergestellt werden müssen, sondern dass das hinter dem organischen strahlungsemittierenden Bauelement 2 angeordnete Trägerelement 1 in Form eines Hausnummern- oder Hinweisschildes sehr leicht ausgetauscht werden kann.

Das gleiche Prinzip eignet sich auch sehr gut zur Beleuchtung von Tür- bzw. Namensschildern. Das Namensschild kann bei Tageslicht ohne Beleuchtung sehr gut gelesen werden, bei Dämmerung oder bei Dunkelheit kann das Namens- oder Türschild mit Hilfe des organischen strahlungsemittierenden Bauelements 2 beleuchtet werden und gleichzeitig die gewünschte Information gelesen werden.

Dasselbe gilt für alle Arten von Schildern, Verkehrszeichen, etc.

In all diesen Fällen ist es vorteilhaft , dass die Abstrahlung der im aktiven Bereich 29 des organischen strahlungsemittierenden Bauelements 2 erzeugten elektromagnetischen Strahlung vorwiegend nach hinten, also in Richtung des Trägerelements 1, erfolgt, um ein möglichst hohes Kontrastverhältnis zu erreichen.

## Patentansprüche

1. Strahlungsemittierende Anordnung, umfassend
- ein Trägerelement (1) mit einer zumindest teilweise nicht-transparenten Hauptoberfläche (10) und
- auf dem Trägerelement (1) angeordnet ein organisches strahlungsemittierendes Bauelement (2) mit einer organischen Schichtenfolge (23) mit einem aktiven Bereich zwischen einer zumindest teilweise transparenten ersten Elektrode (21) und einer zumindest teilweise transparenten zweiten Elektrode (22),
wobei
- der aktive Bereich (29) geeignet ist, in einem eingeschalteten Betriebszustand elektromagnetische Strahlung (91, 93) zu erzeugen,
- die strahlungsemittierende Anordnung auf der vom Trägerelement (1) abgewandten Seite des organischen strahlungsemittierenden Bauelements (2) eine Strahlungsaustrittsfläche (3) zur Abstrahlung der elektromagnetischen Strahlung (92, 93) aufweist,
- die zumindest teilweise nicht-transparente Hauptoberfläche (10) des Trägerelements (1) in einem ausgeschalteten Betriebszustand des organischen strahlungsemittierenden Bauelements (2) von einem externen Beobachter durch die Strahlungsaustrittsfläche (3) hindurch wahrnehmbar ist,
wobei das organische strahlungsemittierende Bauelement (2) eine Abstrahlcharakteristik der im aktiven Bereich (29) erzeugten elektromagnetischen Strahlung (91, 93) mit einer ersten Intensität in Richtung des Trägerelements (1) und einer zweiten Intensität in Richtung der Strahlungsaustrittsfläche (3) aufweist, die zumindest teilweise nicht-transparente Hauptoberfläche (10) des Trägerelements (1) durch die elektromagnetische Strahlung (91) mit der ersten Intensität beleuchtet wird und die elektromagnetische Strahlung (91) mit der ersten Intensität zumindest teilweise in Richtung der Strahlungsaustrittsfläche (3) reflektiert wird, **dadurch gekennzeichnet, dass** die zweite Intensität kleiner als die erste Intensität ist, sodass die nicht-transparente Hauptoberfläche (10) im eingeschalteten Betriebszustand des organischen strahlungsemittierenden Bauelements (2) beleuchtet wahrnehmbar ist.

2. Anordnung nach Anspruch 1, wobei
- die zumindest teilweise nicht-transparente Hauptoberfläche (10) des Trägerelements (1) vom organischen strahlungsemittierenden Bauelement (2) abgewandt angeordnet ist und
- das Trägerelement (1) auf der dem organischen strahlungsemittierenden Bauelement (2) zugewandten Seite ein transparentes Material umfassend Glas und/oder Kunststoff aufweist.

3. Anordnung nach Anspruch 1, wobei
- die zumindest teilweise nicht-transparente Hauptoberfläche (10) des Trägerelements (1) dem organischen strahlungsemittierenden Bauelement (2) zugewandt angeordnet ist.

4. Anordnung nach dem vorherigen Anspruch, wobei
- das Trägerelement (1) aus zumindest einem oder mehreren nicht-transparenten Materialien besteht.

5. Anordnung nach einem der vorherigen Ansprüche, wobei
- die zumindest teilweise nicht-transparente Hauptoberfläche (10) des Trägerelements (1) eine Beschichtung mit zumindest einem oder mehreren nicht-transparenten Materialien umfasst.

6. Anordnung nach Anspruch 4 oder 5, wobei
- das zumindest eine oder die mehreren nicht-transparenten Materialien ausgewählt sind aus einer Gruppe, wobei die Gruppe gebildet wird durch: Stein, Holz, Kunststoff, Textilien, Metall, Metalllegierung, Papier, Karton, Anstrichstoff.

7. Anordnung nach einem der vorherigen Ansprüche, wobei
- zwischen dem Trägerelement (1) und dem organischen strahlungsemittierenden Bauelement (2) zumindest eine Zwischenschicht (4) angeordnet ist, die zumindest eines oder mehrere transparente Materialien aus einer Gruppe aufweist, wobei die Gruppe gebildet wird durch: Glas, Kunststoff, Klebstoff, Halbleiter, ein amorphes Material, ein kristallines Material, Flüssigkeit, Gas.

8. Anordnung nach einem der Ansprüche 1 bis 7, wobei
- das organische strahlungsemittierende Bauelement (2) ein Substrat (20) aufweist und
- das Substrat (20) zwischen dem Trägerelement (1) und der organischen Schichtenfolge (23) angeordnet ist.

9. Anordnung nach einem der Ansprüche 1 bis 7, wobei
- das organische strahlungsemittierende Bauelement (2) ein Substrat (20) aufweist und
- die organische Schichtenfolge (23) zwischen dem Trägerelement (1) und dem Substrat (20) angeordnet ist.

10. Anordnung nach einem der Ansprüche 1 bis 7, wobei
- das Trägerelement (1) als Substrat (20) für das organische strahlungsemittierende Bauelement (2) ausgeführt ist.

11. Anordnung nach einem der vorherigen Ansprüche, wobei
- auf der dem organischen strahlungsemittierenden Bauelement (2) zugewandten Seite des Trägerelements (1) eine Filterschicht (5) angeordnet ist, die einen wellenlängenabhängigen und/oder einen intensitätsabhängigen Transmissionskoeffizienten aufweist.

12. Anordnung nach dem vorherigen Anspruch, wobei
- die Filterschicht (5) einen absorbierenden Farbstoff, einen Wellenlängenkonversionsstoff, ein sättigbares Absorbermaterial, einen spannungsabhängigen Transmissionskoeffizienten oder eine Kombination daraus aufweist.

## Claims

1. A radiation-emitting arrangement, comprising
- a carrier element (1) having an at least partly non-transparent main surface (10) and
- arranged on the carrier element (1), an organic radiation-emitting component (2) having an organic layer sequence (23) with an active region between an at least partly transparent first electrode (21) and an at least partly transparent second electrode (22),
wherein
- the active region (29) is suitable for generating electromagnetic radiation (91, 93) in a switched-on operating state,
- the radiation-emitting arrangement has a radiation exit area (3) for emitting the electromagnetic radiation (92, 93) on that side of the organic radiation-emitting component (2) which faces away from the carrier element (1),
- the at least partly non-transparent main surface (10) of the carrier element (1) is perceptible by an external observer through the radiation exit area (3) in a switched-off operating state of the organic radiation-emitting component (2),
wherein
the organic radiation-emitting component (2) has an emission characteristic of the electromagnetic radiation (91, 93) generated in the active region (29) with a first intensity in the direction of the carrier element (1) and a second intensity in the direction of the radiation exit area (3), the at least partly non-transparent main surface (10) of the carrier element (1) is illuminated by the electromagnetic radiation (91) with the first intensity and the electromagnetic radiation (91) with the first intensity is reflected at least partly in the direction of the radiation exit area (3),
**characterized in that** the second intensity is less than the first intensity, so that the non-transparent main surface (10) is perceptible illuminated in the switched-on state of the organic radiation-emitting component (2) .

2. The arrangement as claimed in claim 1, wherein
- the at least partly non-transparent main surface (10) of the carrier element (1) is arranged in a manner facing away from the organic radiation-emitting component (2), and
- the carrier element (1) comprises a transparent material comprising glass and/or plastic on the side facing the organic radiation-emitting component (2).

3. The arrangement as claimed in claim 1, wherein
- the at least partly non-transparent main surface (10) of the carrier element (1) is arranged in a manner facing the organic radiation-emitting component (2).

4. The arrangement as claimed in the preceding claim,
wherein
- the carrier element (1) consists of at least one or more non-transparent materials.

5. The arrangement as claimed in any of the preceding claims, wherein
- the at least partly non-transparent main surface (10) of the carrier element (1) comprises a coating comprising at least one or more non-transparent materials.

6. The arrangement as claimed in claim 4 or 5, wherein
- the at least one or more non-transparent materials are selected from a group, wherein the group is formed by: stone, wood, plastic, textiles, metal, metal alloy, paper, cardboard, covering substance.

7. The arrangement as claimed in any of the preceding claims, wherein
- at least one intermediate layer (4) is arranged between the carrier element (1) and the organic radiation-emitting component (2), said at least one intermediate layer comprising at least one or more transparent materials from a group, wherein the group is formed by: glass, plastic, adhesive, semiconductor, an amorphous material, a crystalline material, liquid, gas.

8. The arrangement as claimed in any of claims 1 to 7,
wherein
- the organic radiation-emitting component (2) has a substrate (20), and
- the substrate (20) is arranged between the carrier element (1) and the organic layer sequence (23).

9. The arrangement as claimed in any of claims 1 to 7,
wherein
- the organic radiation-emitting component (2) has a substrate (20), and
- the organic layer sequence (23) is arranged between the carrier element (1) and the substrate (20).

10. The arrangement as claimed in any of claims 1 to 7,
wherein
- the carrier element (1) is embodied as a substrate (20) for the organic radiation-emitting component (2).

11. The arrangement as claimed in any of the preceding claims, wherein
- a filter layer (5) having a wavelength-dependent and/or an intensity-dependent transmission coefficient is arranged on that side of the carrier element (1) which faces the organic radiation-emitting component (2).

12. The arrangement as claimed in the preceding claim,
wherein
- the filter layer (5) comprises an absorbent dye, a wavelength conversion substance, a saturable absorber material, a voltage-dependent transmission coefficient or a combination thereof.

## Revendications

1. Dispositif d'émission de rayonnement, comprenant
- un élément porteur (1) ayant une surface principale (10) au moins partiellement non transparente et
- sur l'élément porteur (1), un composant organique émetteur de rayonnement (2) présentant une séquence de couches organiques (23) avec une zone active entre une première électrode au moins partiellement transparente (21) et une deuxième électrode au moins partiellement transparente (22),
dans lequel
- la région active (29) est adaptée pour générer des rayonnements électromagnétiques (91, 93) dans un état de fonctionnement activé,
- le dispositif d'émission de rayonnement présente une face de sortie du rayonnement (3) pour l'émission du rayonnement électromagnétique (92, 93) sur le côté du composant organique émetteur de rayonnement (2) qui est opposé à l'élément porteur (1),
- la surface principale (10) au moins partiellement non transparente de l'élément porteur (1) est perceptible par un observateur extérieur à travers la face de sortie du rayonnement (3) dans un état de fonctionnement désactivé du composant organique émetteur de rayonnement (2),
dans lequel
le composant organique émetteur de rayonnement (2) présente une caractéristique d'émission du rayonnement électromagnétique (91, 93) généré dans la région active (29) avec une première intensité en direction de l'élément porteur (1) et une deuxième intensité en direction de la face de sortie du rayonnement (3), la surface principale (10) au moins partiellement non transparente de l'élément porteur (1) est éclairée par le rayonnement électromagnétique (91) de la première intensité et le rayonnement électromagnétique (91) de la première intensité est réfléchi au moins partiellement en direction de la face de sortie du rayonnement (3),
**caractérisé en ce que** la deuxième intensité est inférieure à la première intensité, de sorte que la surface principale (10) non transparente est perceptiblement éclairée à l'état de fonctionnement du composant organique émetteur de rayonnement (2).

2. Dispositif selon la revendication 1, dans lequel
- la surface principale (10) au moins partiellement non transparente de l'élément porteur (1) est disposée de manière à être opposée au composant organique émetteur de rayonnement (2), et
- l'élément porteur (1) est constitué d'un matériau transparent comprenant du verre et/ou du plastique sur la face tournée vers le composant organique émetteur de rayonnement (2).

3. Dispositif selon la revendication 1, dans lequel
- la surface principale (10) au moins partiellement non transparente de l'élément porteur (1) est disposée de manière à faire face au composant organique émetteur de rayonnement (2).

4. Dispositif selon la revendication précédente, dans lequel
- l'élément porteur (1) est constitué d'au moins un ou plusieurs matériaux non transparents.

5. Dispositif selon l'une des revendications précédentes, dans lequel
- la surface principale (10) au moins partiellement non transparente de l'élément porteur (1) comprend un revêtement comprenant au moins un ou plusieurs matériaux non transparents.

6. Dispositif selon la revendication 4 ou 5, dans lequel
- le au moins un ou plusieurs matériaux non transparents sont choisis dans un groupe, dans lequel le groupe est formé par : pierre, bois, plastique, textiles, métal, alliage métallique, papier, carton, substance de recouvrement.

7. Dispositif selon l'une des revendications précédentes, dans lequel
- au moins une couche intermédiaire (4) est disposée entre l'élément porteur (1) et le composant organique émetteur de rayonnement (2), ladite au moins une couche intermédiaire comprenant au moins un ou plusieurs matériaux transparents d'un groupe, dans lequel le groupe est formé par : verre, plastique, adhésif, semiconducteur, un matériau amorphe, un matériau cristallin, liquide, gaz.

8. Dispositif selon l'une des revendications 1 à 7, dans lequel
- le composant organique émetteur de rayonnement (2) a un substrat (20), et
- le substrat (20) est disposé entre l'élément porteur (1) et la séquence de couches organiques (23).

9. Dispositif selon l'une des revendications 1 à 7, dans lequel
- le composant organique émetteur de rayonnement (2) a un substrat (20), et
- la séquence de couches organiques (23) est disposée entre l'élément porteur (1) et le substrat (20).

10. Dispositif selon l'une des revendications 1 à 7, dans lequel
- l'élément porteur (1) se présente sous forme d'un substrat (20) pour le composant organique émettant des radiations (2) .

11. Dispositif selon l'une des revendications précédentes, dans lequel
- une couche filtrante (5) ayant un coefficient de transmission dépendant de la longueur d'onde et/ou de l'intensité est disposée sur le côté de l'élément porteur (1) qui face au composant organique émetteur de rayonnement (2).

12. Dispositif selon la revendication précédente, dans lequel
- la couche filtrante (5) comprend un colorant absorbant, une substance de conversion de longueur d'onde, un matériau absorbant saturable, un coefficient de transmission dépendant de la tension ou une combinaison de ces éléments.
